Europäisches Patentamt

(19) European Patent Office (11) Publication number: **0 107 337**

Office européen des brevets **B1**

(12) **EUROPEAN PATENT SPECIFICATION**

(45) Date of publication of patent specification: **16.08.90** (51) Int. Cl.⁵: **G 11 C 27/02**

(21) Application number: **83305517.1**

(22) Date of filing: **20.09.83**

(54) Improvements in or relating to sample-and-hold circuits and methods.

(30) Priority: **29.09.82 US 426293**

(43) Date of publication of application:
**02.05.84 Bulletin 84/18**

(45) Publication of the grant of the patent:
**16.08.90 Bulletin 90/33**

(84) Designated Contracting States:
**BE DE FR IT NL SE**

(56) References cited:
**GB-A-1 417 731**
**US-A-4 308 468**
**IEEE JOURNAL OF SOLID-STATE CIRCUITS, vol.**
**SC-15, no. 6, December 1980, pages 945-949,**
**IEEE, New York, US; F. GASPARIK: "A precision**
**autozeroing sample and hold integrated circuit"**

**CPEM DIGEST 1972, CONFERENCE ON**
**PRECISION ELECTROMAGNETIC**
**MEASUREMENTS, 26th-29th June 1972,**
**Boulder, Colorado, pages 88-90, IEEE, New York,**
**US; G.J. FRYE: "Estimation of sampling gate**
**error due to shunt capacitance"**

**PATENTS ABSTRACTS OF JAPAN, vol. 6, no. 59**
**(P-110)937r, 16th April 1982; & JP - A - 56 169**
**291 (NIPPON DENKI K.K.) 25-12-1981**

(73) Proprietor: **Western Electric Company,**
**Incorporated**
**222 Broadway**
**New York, NY 10038 (US)**

(72) Inventor: **Lie, Hans Peter**
**132 Briarwood Drive, East**
**Berkley Heights New Jersey 07922 (US)**

(74) Representative: **Buckley, Christopher Simon**
**Thirsk et al**
**Western Electric Company Limited 5**
**Mornington Road**
**Woodford Green Essex IG8 OTU (GB)**

(56) References cited:
**IEEE Journal of Solid-State Circuits vol. sc 16,**
**No. 4 Aug. 1981 p. 367-371**

EP 0 107 337 B1

## Description

The invention relates to feedback sample-and-hold circuits and methods.

Sample-and-hold circuits are used, for example, in electronic integrated circuits for delay functions and find application alone and in banks of stages for time domain filtering, such as in a transversal filter.

The invention will be described by way of example with reference to the accompanying drawings, in which:

Fig. 1 is a schematic circuit diagram of a portion of a known feedback sample-and-hold circuit stage bank;

Fig. 2 is a schematic circuit diagram of a portion of a feedback sample-and-hold circuit stage bank embodying the invention; and

Fig. 3 is a schematic circuit diagram of the circuit stage of Fig. 2 modified to include an additional correction zeroing switch.

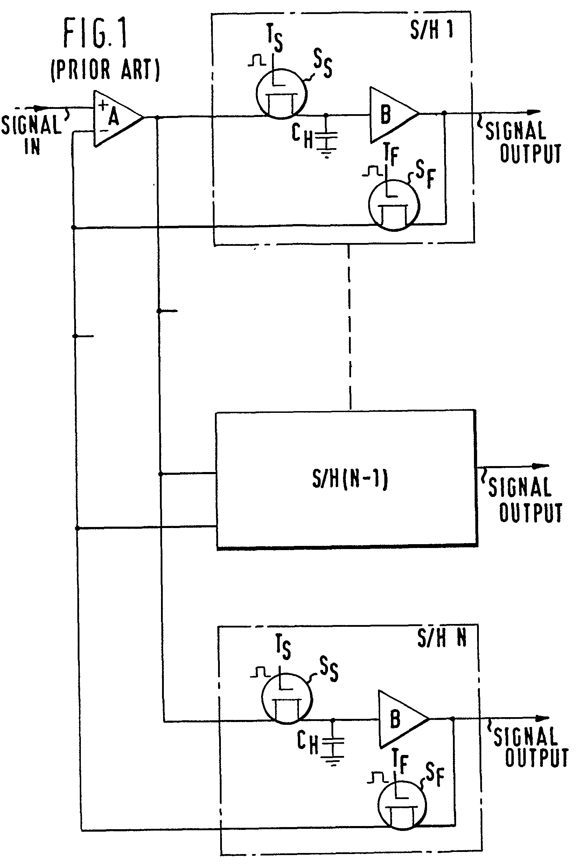

Referring now to Fig. 1, in a known arrangement of N sample-and-hold circuit stages interconnected as a bank to work in conjunction with a common operational amplifier A each of the stages, shown enclosed by a broken line, includes a basic sample-and-hold circuit section and a switched feedback path connecting the output of the sample-and-hold circuit of the inverting input of the amplifier A. The sample-and-hold circuit sections each include a sampling switch $S_S$, a holding capacitor $C_H$, and a buffer B. The sampling switches $S_S$ are operated successively by pulses of a set of individually associated primary sampling switching pulse trains $T_S$. The feedback sections include feedback enabling switches $S_F$, which are operated successively by pulses of a second set of switching pulse trains $F_F$ so that the feedback for any particular stage is enabled during the entire sample-and-hold process of that stage. The details of the switching pulse electrical connections to the sampling switches $S_S$ and the feedback enabling switches $S_F$ are readily apparent to those skilled in the art and are not shown in the figure for the same of clarity.

For understanding the general mode of operation of one of the stages, it is useful first to assume that its sampling switch $S_S$ is in the conducting, closed condition, so that the signal output tracks the signal input. When the sampling switch $S_S$ is opened, the output is held at a fixed hold value. If the switch $S_S$ is a perfect switch and the amplifier A and the buffer B are ideal, then the hold output will be precisely the same magnitude as the input which was present when the sampling switch $S_S$ was opened. The feedback loop in conjunction with the amplifier A reduces the effect of a voltage offset in the buffer B and in the sampling switch $S_S$ on the signal output. The sampling switch $S_S$ is generally an electronic switching device and is particularly well implemented by the use of one or more FET (field effect transistor) devices such as MOS (metal-oxide-semiconductor) transistors.

While MOS devices are particularly suitable for use as electronic switching devices, they are nevertheless not perfect. Because of coupling between the gate, source, and drain of the MOS device, unwanted error change in the form of switching charge feedthrough is fed onto the holding capacitor $C_H$ after the MOS sampling switch $S_S$ is opened. At this time, since the sampling switch $S_S$ no longer conducts from source to drain, the operational amplifier A can no longer act to preserve the correct charge on the holding capacitor $C_H$. As a result, there arises a hold voltage offset, the magnitude of which is determined by the amount of charge feedthrough from the sampling switch $S_S$ to the holding capacitor $C_H$ divided by the capacitance value of the holding capacitor $C_H$. Since the capacitance magnitude of the holding capacitor $C_H$ limits the speed with which it can be charged, it is not possible to decrease the holding voltage offset by increasing at will the capacitance magnitude of the holding capacitor $C_H$.

One known way of decreasing the hold voltage offset has been to provide a charge feedthrough compensation switch across the sampling switch $S_S$. This is described, for example, in U.S. Patent 4,308,468. Such an approach significantly reduces the gross effects of the feedthrough charge for a particular switching device, but it does not deal with the effects of variations in feedthrough charge characteristics from one switching device to the next. Since in actual practice no two switches are identical, the feedthrough charge effect of each sampling switch $S_S$ is reduced by its associated compensation switch only to the extent that the feedthrough charge effects of both are identical. Thus, for a bank of feedback sample-and-hold circuits, the variations in the net charge feedthrough of the sampling switches $S_S$ and any compensating switches which may be connected across these still results in variations among the holding capacitor voltages, even when all the stages are sampling an identical signal. This produces a fixed pattern noise in a configuration in which the outputs of the sample-and-hold circuits are repeatedly sequentially sampled. This problem is discussed in relation to transversal filtering in, for example, "A Programmable Transversal Filter for Voice-Frequency Applications" by Sunter et al. in *IEEE Journal of Solid-State Circuits*, Vol. SC-16, No. 4, Aug. 1981, pp. 367—371.

According to this invention there is provided a sample-and-hold circuit as claimed in Claim 1.

In one embodiment of the invention, a correction sampling switch and correction holding capacitor are connected serially, respectively, between the output of the amplifier and a reference potential point, normally ground potential, to provide the correction sample-and-hold circuit. A correction coupling capacitor is connected to the common node of the correction sampling switch and the correction holding capacitor on one side and to the common node of the primary sampling switch and the primary holding capacitor on its other side, thereby coupling an attenuated correction circuit output to the primary signal path.

For a brief time after the primary circuit has switched to its hold condition, the correction circuit provides an attenuated, secondary path for a feedback correction of the signal held in the primary circuit. The attenuating coupling correspondingly reduces the effect of any switching charge feedthrough error which would be likewise introduced by the switching of the secondary, correction circuit to its hold condition.

In another embodiment of the invention, there is provided a correction zeroing switch connected between a reference potential and the common node of the correction holding capacitor and the correction sampling switch for periodically zeroing that node, so that large signal amplitudes can be better corrected.

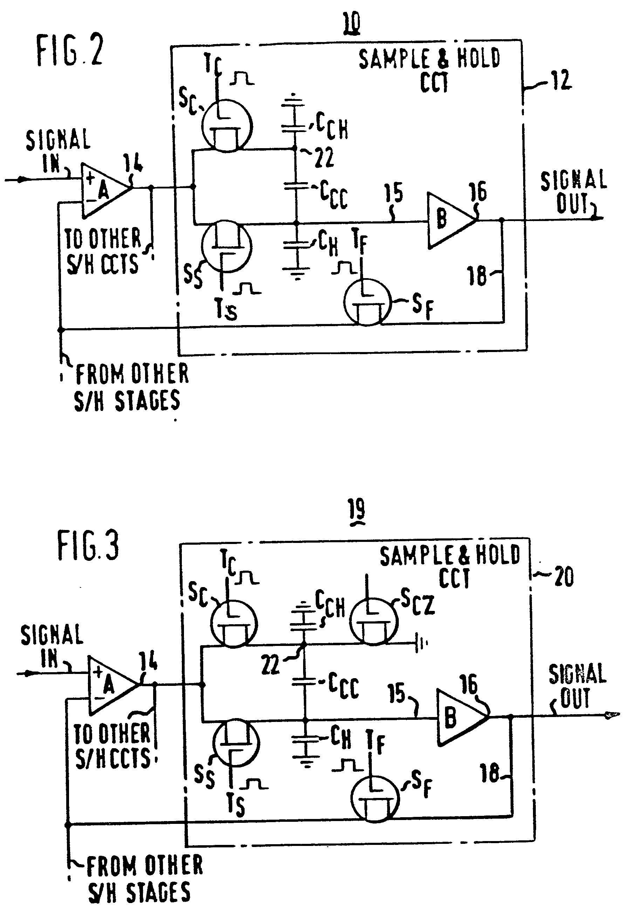

Referring now to Fig. 2, the first stage portion of a bank 10 of a plurality of MOS device feedback sample-and-hold circuit stages 12, in which all capacitors and transistor switches are MOS devices, includes a high performance, high gain operational amplifier A. The amplifier A has inverting (−) and noninverting (+) input ports and an output port 14. While only the first of the stages 12 is shown, it is to be understood that there are additional stages connected as a bank, with the amplifier A being common to them.

Each stage 12 includes a buffer B having an input port 15 and an output port 16. The output port 14 of the amplifier A is connected through an MOS transistor primary sampling switch $S_S$ to the input port 15 of the buffer B. The output port 16 of the buffer is connected to the inverting input port (−) of the amplifier A by a feedback path 18 in which there is a feedback enabling switch $S_F$.

A primary holding capacitor $C_H$ is connected between the input port 15 of the buffer B and ground potential. A correction coupling capacitor $C_{CC}$ with a capacitance substantially less than that of the holding capacitor $C_H$ and a correction holding capacitor $C_{CH}$ of about the same capacitance as the primary holding capacitor $C_H$ are connected in series, respectively, between the buffer B input port 15 and ground potential. A secondary, correction sampling switch $S_C$ couples the output port 14 of the amplifier A to the common node 22 of the correction holding capacitor $C_{CH}$ and the correction coupling capacitor $C_{CC}$. The switches $S_S$, $S_C$ are similar to each other. Each switch consists of an N-channel and a P-channel MOS transistor connected in parallel with their gates driven by appropriate switching control pulses. This known arrangement minimizes the charge feedthrough of the switch, since the complementary characteristics of the transistors leads to a substantial mutual cancellation of their individual charge feedthroughs. Signal input to the circuit 10 is to be noninverting input port (+) of the amplifier A. Signal output from the stage 12 is from the output port 16 of the buffer B.

The circuit configuration of the stage 12 provides a means by which the feedback loop 18 can be used to correct the hold voltage offset resulting from the opening of the sampling switch $S_S$.

To accomplish this, the amplifier A stores a correction voltage $V_C$ on the correction holding capacitor $C_{CH}$. The charging of the correction holding capacitor $C_{CH}$ transfers charge through the correction coupling capacitor $C_{CC}$ to the holding capacitor $C_H$, thereby correcting the hold voltage offset contributed from the sampling switch $S_S$ charge feedthrough.

The switches $S_S$, $S_C$, $S_F$ are operated at the appropriate times as discussed below by respective switching pulse trains $T_S$, $T_C$, $T_F$ from connection to appropriate sources, not shown in the drawings, as would be readily apparent to one skilled in the art.

The mode of operation is as follows: with the feedback path 18 enabled and both the sampling switch $S_S$ and the correction switch $S_C$ closed during a signal tracking pulse, the output is equal to the input. The sampling switch $S_S$ alone is then opened by the first pulse train $T_S$, leaving the holding capacitor $C_H$ charged to nearly the correct hold voltage value $V_H$, but with an error voltage $V_{error}$ resulting from the charge feedthrough from the sampling switch $S_S$. The correction switch $S_C$ will then provide a secondary path to permit the amplifier A to correct the hold voltage value $V_H$ by charging the correction holding capacitor $C_{CH}$ until the output is again equal to the input. At this time, the correction switch $S_C$ is opened by the second switching pulse train $T_C$. Because the correction coupling capacitor $C_{CC}$ is of much smaller magnitude than the primary holding capacitor $C_H$, the offset voltage on the correction holding capacitor $C_{CH}$ caused by opening the correction switch $S_C$ will be attenuated with respect to the output voltage $V_{out}$ by approximately the factor

$$\frac{C_{CC}}{C_H}$$

A modification of the circuit 10 is the circuit 19 of Fig. 3, which is similar to the circuit 10 except that its stage 20 is provided additionally with a correction zeroing switch $S_{CZ}$. This additional switch is connected between the common node 22 of the correction coupling and holding capacitors $C_{CC}$, $C_{CH}$ and ground potential and is also operated by the first pulse train $T_S$. This feature facilitates correction for large signal amplitudes by bringing the common node 22 to zero before each hold.

In the operation of the stage 20, the primary sampling switch $S_S$ and the correction zeroing switch $S_{CZ}$ are first closed during tracking of the signal, with the correction switch $S_C$ being open. Then the sampling switch $S_S$ and the correction zeroing switch $S_{CZ}$ are opened simultaneously by the primary sampling pulse train $T_S$, while the correction switch $S_C$ is simultaneously closed by the correction pulse train $T_C$. Since the voltage on the correction holding capacitor $C_{CH}$ is initially zero, or ground potential, the amplifier A can swing the correction voltage $V_C$ from zero to full scale in either direction, thereby providing the maximum correction voltage for large signal amplitudes. A disadvantage of this arrangement, however, is that the amplifier A will have to slew back to zero, or near zero, when a large input signal is present. This takes extra time, and thereby somewhat lengthens the time required for the holding function.

The objective of circuit embodying the invention is to store a correction voltage which will substantially reduce the effect of the charge feedthrough from the primary sampling switch $S_S$. Since the correction voltage is also stored, a configuration must be used in which the effect of switch feedthrough when storing the correction voltage is less than the feedthrough of the primary sample-and-hold circuit. Since the error voltage caused by opening the primary sampling switch $S_S$ is of the order of ten millivolts, whereas the signal being stored is on the other of several volts, the stored correction voltage can be attenuated in its effect on the signal output, and there will still be sufficient range in the correction voltage to perform the necessary correction. Assuming that the correction voltage is stored using a switching means and a holding capacitor similar to the primary holding capacitor $C_H$, a bank of such circuits will exhibit the same variation in the correction voltage that the primary sample-and-hold circuits of the bank of stages exhibit in the output voltage. If, then, the correction voltages are attenuated in their effect on the respective signal outputs, the variation in the correction voltages produced by random differences in the correction switches $S_C$ will also be correspondingly reduced. From the viewpiont of obtaining the minimum fixed pattern noise, the attenuation of the correction signal should be as large as it can be, while ensuring that the attenuated error voltage is large enough to correct for the worst error produced by feedthrough from the sampling switches $S_S$. However, since the attenuation of the correction voltage is an element in the feedback path loop associated with the amplifier A, it affects the settling time of the loop. Thus, constraints on the time allowed for the entire sample-and-hold operation may impose a more severe restriction on the amount of attentuation that can be used.

For typical practical application of the sample-and-hold circuit 10, e.g. where the input signal to the amplifier is audio frequency or higher, it is advisable to provide a sample-and-hold of the incoming signal before the input port of the amplifier. This prevents the signal level at the output port of the amplifier from undergoing significant change during the time that the correction sample-and-hold capacitor is being charged and thereby interfering with the accuracy of the correction.

Although the above discussion involves a bank 10 of sample-and-hold stages 12 which are coupled to each other, it should be understood that a single stage 12 could also be used alone with the amplifier A to perform a useful sample-and-hold function.

The buffer B prevents the circuitry connected to the signal output from altering the charge on the holding capacitor $C_H$. While in the stage 12 of the bank 10 it is a transistor, it could also be a nominal unity gain amplifier of another sort.

The reference potentials at various nodes of sample-and-hold circuit need not necessarily be the same. In fact, in some instances it may be advantageous that they have different levels.

## Claims

1. A sample-and-hold circuit including an amplifier (A) for receiving an input signal from an input signal node and a feedback signal from the output (16) of a buffer (B), a primary sampling switch $(S_S)$ connected in a circuit path between the input signal node and an input (15) of the buffer (B), a primary holding capacitor $(C_H)$ connected between the input of the buffer (B) and a reference potential point, and characterized by correction sample-and-hold means including a correction holding capacitor $(C_{CH})$ having one side connected through a correction sampling switch $(S_C)$ to the output (14) of the amplifier (A), and the other side connected to a reference potential point, a correction coupling capacitor $(C_{CC})$ for coupling a correction signal from the one side of the correction holding capacitor $(C_{CH})$ to the primary holding capacitor, the correction coupling capacitor $(C_{CC})$ having a capacitance substantially less than that of the primary holding capacitor $(C_H)$, and control means for keeping the correction sampling switch $(S_C)$ closed for a predetermined period of time after opening of the primary sampling switch $(S_S)$ in order to provide a correction of a change in the level of the signal on the primary holding capacitor $(C_H)$ caused by the switching feedthrough error resulting from the opening of the primary sampling switch.

2. A circuit as claimed in Claim 1 including a correction zeroing switch $(S_{CZ})$ connected between a reference potential point and the one side of the correction holding capacitor $(C_{CH})$, the control means serving to open the correction zeroing switch $(S_{CZ})$ when the primary sampling switch $(S_S)$ opens.

## Patentansprüche

1. Abtast- und Halteschaltung mit einem Verstärker (A) zur Aufnahme eines Eingangssignals von einem Eingangssignalknoten und eines Rückkopplungssignale vom Ausgang (16) eines Puffers (B), mit einem primären Abtastschalter $(S_S)$, der in einen Stromweg zwischen dem Eingangssignalknoten und einem Eingang (15) des Puffers (B) gelegt ist und mit einem primären Haltekondensator $(C_H)$, der zwischen den Eingang des Puffers (B) und einen Bezugspotentialpunkt geschaltet ist, gekennzeichnet durch

eine Korrektur-Abtast- und Halteeinrichtung mit einem Korrektur-Haltekondensator $(C_{CH})$, dessen eine Seite über einen Korrektur-Abtastschalter $(S_C)$ mit dem Ausgang (14) des Verstärkers (A) und dessen andere Seite mit einem Bezugspotentialpunkt verbunden ist,

einen Korrektur-Koppelkondensator ($C_{CC}$) zur Lieferung eines Korrektursignals von der einen Seite des Korrektur-Haltekondensators ($C_{CH}$) an den primären Haltekondensator, wobei der Korrektur-Koppelkondensator ($C_{CC}$) eine wesentlich kleinere Kapazität als der primäre Haltekondensator ($C_H$) hat, und

eine Steuereinrichtung, die den Korrektur-Abtastschalter ($S_C$) für eine vorbestimmte Zeitspanne nach Öffnen des primären Abtastschalters ($S_S$) geschlossen hält, um eine Korrektur für die Änderung des Signalpegels im primären Haltekondensator ($C_H$) zu bewirken, die durch den sich aus dem Öffnen des primären Abtastschalters ergebenden Durchschaltfehler zu bewirken.

2. Schaltung nach Anspruch 1, mit einem Korrektur-Nullsetzschalter ($S_{CZ}$), der zwischen einen Bezugspotentialpunkt und die eine Seite des Korrektur-Haltekondensators ($C_{CH}$) geschaltet ist, wobei die Steuereinrichtung den Korrektur-Nullsetzschalter ($S_{CZ}$) öffnet, wenn der primäre Abtastschalter ($S_S$) öffnet.

**Revendications**

1. Un circuit échantillonneur-bloqueur comprenant un amplificateur (A) destiné à recevoir un signal d'entrée provenant d'un noeud de signal d'entrée et un signal de réaction provenant de la sortie (16) d'un amplificateur-séparateur (B), un interrupteur d'échantillonnage primaire ($S_S$) connecté dans un circuit entre le noeud de signal d'entrée et une entrée (15) de l'amplificateur-séparateur (B), un condensateur de blocage primaire ($C_H$) connecté entre l'entrée de l'amplificateur-séparateur (B) et un point de potentiel de référence, et caractérise par des moyens échantillonneurs-bloqueurs de correction comprenant un condensateur de blocage de correction ($C_{CH}$) dont un premier côté est connecté à la sortie (14) de l'amplificateur (A) par l'intermédiaire d'un interrupteur d'échantillonnage de correction ($S_C$), et l'autre côté est connecté à un point de potentiel de référence, un condensateur de couplage de correction ($C_{CC}$) destiné à appliquer au condensateur de blocage primaire un signal de correction qui provient du premier côté du condensateur de blocage de correction ($C_C$), le condensateur de couplage de correction ($C_C$) ayant une capacité notablement inférieure à celle du condensateur de blocage primaire ($C_H$), et des moyens de commande pour maintenir l'interrupteur d'échantillonnage de correction ($S_C$) fermé pendant une durée prédéterminée après l'ouverture de l'interrupteur d'échantillonnage primaire ($S_S$), dans le but de procurer une correction d'un changement du niveau du signal sur le condensateur de blocage primaire ($C_H$) qui est occasionné par l'erreur de transmission directe au moment de la commutation, qui résulte de l'ouverture de l'interrupteur d'échantillonnage primaire.

2. Un circuit selon la revendication 1, comprenant un interrupteur de mise à zéro de correction ($S_{CZ}$) qui est connecté entre un point de potentiel de référence et le premier côté du condensateur de blocage de correction ($C_{CH}$), les moyens de commande ayant pour fonction d'ouvrir l'interrupteur de mise à zéro de correction ($S_{CZ}$) lorsque l'interrupteur d'échantillonnage primaire ($S_S$) s'ouvre.

FIG.1
(PRIOR ART)

EP 0 107 337 B1

FIG.2

FIG.3

2